# FASCICULE DE BREVET EUROPEEN

(11) **EP 3 518 307 B1**
(45) Date de publication et mention de la délivrance du brevet: **04.05.2022**
(21) Numéro de dépôt: 19154029.3
(22) Date de dépôt: 28.01.2019
(51) Int. Cl.: H01M 10/0562, H01M 6/18, H01M 6/40, C03B 5/00, H01M 10/052, H01M 50/116, H01M 10/04, H01L 23/31, H01L 21/56, G06F 13/42, H01L 23/29

(54) **PROCÉDÉ D'ENCAPSULATION D'UN DISPOSITIF MICROÉLECTRONIQUE, PAR DES SUBSTRATS FINS OU ULTRAFINS, FACILEMENT MANIPULABLES**
EINKAPSELUNGSVERFAHREN EINER MIKROELEKTRONISCHEN VORRICHTUNG MIT DÜNNEN ODER ULTRADÜNNEN SUBSTRATEN, DIE LEICHT HANDHABBAR SIND
METHOD FOR ENCAPSULATING A MICROELECTRONIC DEVICE, BY EASY-TO-HANDLE FINE OR ULTRAFINE SUBSTRATES

(30) Priorité: 30.01.2018 FR 1850733
(43) Date de publication de la demande: 31.07.2019
(73) Titulaire: Commissariat à l'énergie atomique et aux énergies alternatives, 75015 Paris (FR)
(72) Inventeur: BEDJAOUI, Messaoud, 38340 VOREPPE (FR)
(74) Mandataire: Brevalex

(56) Documents cités:
- EP-A1- 2 065 929
- EP-A1- 3 159 302
- FR-A1- 2 879 889
- US-A1- 2010 258 882

## Description

La présente invention se rapporte à un procédé d'encapsulation d'un dispositif microélectronique, par des substrats fins ou ultrafins facilement manipulables.

La présente invention concerne également une structure mircroélectronique, obtenue par un tel procédé.

Ces dernières années, les composants microélectroniques, et plus particulièrement, les microbatteries tout solides en couches minces sont devenues incontournables dans le développement des systèmes intelligents embarqués. Ces systèmes intelligents sont, par exemple, utilisés, dans les applications dites internet des objets (« Internet of Things »), le stockage d'énergie, la récupération de l'énergie, l'électronique organique et inorganique, ou encore le domaine de la puissance.

Le développement de ces systèmes intelligents doit mener vers une miniaturisation des composants microélectroniques, et parallèlement à l'utilisation de substrats de support de plus en plus fins. Les substrats utilisés pour ces systèmes doivent être fins (typiquement ayant une épaisseur inférieure à 100µm) voire même ultrafins (épaisseur inférieure à 50µm).

Les dispositifs microélectroniques, et notamment les microbatteries au lithium, présentent une très forte sensibilité aux éléments atmosphériques tels que l'oxygène et la vapeur d'eau. Ces dispositifs doivent donc être encapsulés pour garantir leur intégrité électronique ou électrochimique mais aussi mécanique dans le temps. Les performances des systèmes d'encapsulation sont fréquemment exprimées en termes de vitesses de transmission de la vapeur d'eau (WVTR pour « Water Vapor Transmission Rate ») ou encore en vitesse de transmission de l'oxygène (OTR pour « Oxygen Transmission Rate »). Dans le cas particulier des microbatteries au lithium, les niveaux WVTR et OTR requis sont respectivement de l'ordre de 10⁻⁴ g/m²/j et de 10⁻⁴ cm³/m²/j.

Sur le plan pratique, pour répondre aux critères de miniaturisation des dispositifs microélectroniques, le capot doit également être fin ou ultrafin tout en garantissant un niveau de protection suffisant.

Afin de faciliter la manipulation des substrats fins et ultrafins, une première solution consiste à utiliser les substrats fragiles (dit « front-end ») en association avec un substrat de rigidification, aussi appelé support rigide ou de renfort pour faciliter leur manipulation et leur maniement durant les étapes technologiques. Cependant, cette solution nécessite de mettre en œuvre une étape de collage, soit directe, sans couche intermédiaire (par exemple comme décrit dans le document FR-A-2893750), soit indirecte avec une couche intermédiaire de nature diélectrique, métallique, polymère ou autre (par exemple comme décrit dans le document US-A-2011/0048611), ainsi qu'une étape de désolidarisation du substrat fin de son support rigide à la fin du procédé, par exemple, en insérant une lame entre le substrat et le support temporaire ou encore en appliquant une force de cisaillement ou de traction sur le substrat. De plus, certaines solutions de collage temporaire ne sont pas adaptées aux dispositifs microélectroniques dont les procédés nécessitent des budgets thermiques avec des températures supérieures à 300°C.

Finalement, de telles étapes de collage et de désolidarisation conduisent à une augmentation des coûts de fabrication et/ou des délais de production.

Une deuxième solution consiste à amincir, par voie chimique ou par voie mécanique, des substrats rigides standards à la fin des procédés de réalisation des dispositifs. Par exemple, le document EP 3 159 302 A1 décrit l'encapsulation d'un composant microélectronique entre un capot et un substrat de support, puis l'amincissement de la face arrière du substrat de support, par polissage mécanochimique (CMP). La technique d'amincissement par voie chimique est une technique plus douce que la technique d'amincissement par voie mécanique. Cependant, cette solution présente plusieurs inconvénients pour les étapes devant être réalisées en fin de procédé (étapes dites « back-end »). En effet, le problème majeur concerne la manipulation des substrats après amincissement. Les substrats initialement rigides deviennent très fragiles après amincissement, et il est difficile de les manipuler pour réaliser les étapes ultérieures de découpe des composants et/ou après d'intégration avec d'autres composants.

### EXPOSÉ DE L'INVENTION

C'est, par conséquent, un but de la présente invention de proposer un procédé d'encapsulation remédiant aux inconvénients de l'art antérieur et, en particulier, de proposer un procédé d'encapsulation de dispositifs microélectroniques sensibles à l'air et/ou aux températures élevées avec un substrat et/ou un capot fin ou ultrafin, le procédé devant être facile à mettre en œuvre, ne nécessitant pas d'étape de désolidarisation comme dans l'art antérieur et, notamment, permettant de manipuler facilement le substrat et/ou le capot fin ou ultrafin.

Ce but est atteint par un procédé d'encapsulation d'un dispositif microélectronique, disposé sur un substrat de support, avec un capot d'encapsulation comprenant les étapes successives suivantes :
a) fourniture d'un substrat de support, en un premier matériau, comprenant une première face principale sur laquelle est disposé un dispositif microélectronique, une seconde face principale opposée à la première face principale, et une face latérale,
b) dépôt d'une couche de collage, en un deuxième matériau, sur la première face du substrat, autour du dispositif microélectronique,
c) positionnement d'un capot d'encapsulation, en un troisième matériau, comprenant une première face principale, une seconde face principale, opposée à la première face principale, et une face latérale, sur la couche de collage, de manière à fixer le capot d'encapsulation sur le substrat de support, et de manière à encapsuler le dispositif microélectronique,
d) dépôt d'une couche de protection latérale en un quatrième matériau sur la face latérale du substrat de support, sur la face latérale du capot d'encapsulation, sur le pourtour de la seconde face du capot d'encapsulation, et sur le pourtour de la seconde face du substrat de support, la couche de protection latérale délimitant une zone protégée,
e) amincissement de la seconde face principale du substrat de support et/ou de la seconde face principale du capot d'encapsulation en dehors de la zone protégée, par gravure chimique.

Le procédé selon l'invention est simple à mettre en œuvre et nécessite peu d'étapes technologiques. Le procédé de l'invention ne met pas en œuvre d'étapes de solidarisation temporaire et de désolidarisation. A la fin du procédé d'encapsulation, le dispositif microélectronique est encapsulé, d'une part, avec un substrat, pouvant être fin ou ultrafin, et, d'autre part, par un capot pouvant être fin ou ultrafin.

Par fin, on entend une épaisseur inférieure à 200µm, et de préférence inférieure à 100µm, et par ultrafin, on entend une épaisseur inférieure à 50µm.

Le procédé d'amincissement permet de réduire l'épaisseur du substrat et/ou du capot tout en conservant une zone de préhension au niveau du pourtour du substrat et du capot. Au final, la structure obtenue peut être aisément transférée vers des équipements de découpe permettant ainsi une séparation des dispositifs microélectroniques.

L'amincissement est réalisé par gravure chimique. Ces conditions de gravure sont bien contrôlées par rapport à une gravure mécanique.

Le procédé de la présente invention permet d'obtenir des dispositifs miniaturisés dont les dispositifs microélectroniques sont protégés de l'air et de ses oxydants.

Avantageusement, le premier matériau et/ou le troisième matériau sont choisis parmi le verre et le silicium. Ces matériaux présentent de bonnes propriétés barrières.

Selon une première variante avantageuse, le premier matériau et le troisième matériau sont identiques. L'amincissement du substrat de support et du capot d'encapsulation peuvent être réalisés simultanément et à la même vitesse de gravure, par exemple, en immergeant, ou aspergeant, l'ensemble avec une solution de gravure chimique. L'amincissement peut être contrôlé en fonction du temps d'immersion ou d'aspersion et de la composition chimique des liquides utilisés.

Selon une deuxième variante avantageuse, le premier matériau et le troisième matériau sont différents. Il est possible de graver uniquement le capot d'encapsulation ou le substrat de support ou de les graver à vitesses différentes.

Selon un mode de réalisation particulièrement avantageux, lors de l'étape b), la couche de collage recouvre totalement le dispositif microélectronique.

Selon un autre mode de réalisation particulièrement avantageux, lors de l'étape b), la couche de collage forme un cordon de scellement autour du dispositif microélectronique.

Avantageusement, le deuxième matériau et/ou le quatrième matériau est un matériau polymère choisi parmi les époxydes, les éthers, les polysiloxanes, les acryliques, un de leurs copolymères, et le polyéthylène téraphtalate.

Avantageusement, à l'issue de l'étape e), le capot d'encapsulation (400) et/ou le substrat de support (200) ont une épaisseur inférieure ou égale à 100µm, et de préférence, inférieure à 50µm.

Avantageusement, la couche de protection recouvre le pourtour de la première face principale du substrat de support et/ou le pourtour de la première face principale du capot d'encapsulation de préférence sur une longueur allant de 1mm à 5mm.

Avantageusement, la couche de protection latérale recouvre le pourtour de la seconde face principale du substrat de support et/ou le pourtour de la seconde face principale du capot d'encapsulation, de préférence sur une longueur allant de 1mm à 5mm.

Avantageusement, le composant microélectronique est un dispositif électrochimique telle qu'une microbatterie au lithium.

Avantageusement, plusieurs dispositifs microélectroniques, identiques ou différents, sont disposés sur la première face du substrat de support et/ou sur la première face principale du capot d'encapsulation.

Le procédé selon l'invention autorise plusieurs configurations en termes de nombre et de positionnement des dispositifs microélectroniques. Par exemple, il est possible d'empiler deux microbatteries.

L'invention concerne également une structure microélectronique, obtenue par le procédé tel que défini précédemment, comprenant :
- un dispositif microélectronique, par exemple, un dispositif électrochimique telle qu'une microbatterie au lithium,
- un substrat de support, en un premier matériau, comprenant une première face principale sur laquelle est disposé le dispositif microélectronique, une seconde face principale opposée à la première face principale, et une face latérale,
- une couche de collage, en un deuxième matériau, disposée sur la première face du substrat, autour du dispositif microélectronique,
- un capot d'encapsulation, en un troisième matériau, comprenant une première face principale, une seconde face principale, opposée à la première face principale, et une face latérale, fixé sur la couche de collage, et positionner de manière à encapsuler le dispositif microélectronique,
- une couche de protection latérale en un quatrième matériau recouvrant la face latérale du substrat de support, la face latérale du capot d'encapsulation, le pourtour de la seconde face du capot d'encapsulation, et le pourtour de la seconde face du substrat de support, la couche de protection latérale délimitant une zone protégée,
l'épaisseur du substrat de support et/ou du capot d'encapsulation en dehors de la zone protégée étant inférieure, respectivement, à l'épaisseur du substrat de support et/ou du capot de manipulation au niveau de la zone protégée.

Les caractéristiques liées au procédé se retrouvent pour la structure microélectronique.

Une telle structure est facile à manipuler pour réaliser les étapes ultérieures de découpe et/ou après d'intégration avec d'autres composants microélectroniques.

### BRÈVE DESCRIPTION DES DESSINS

La présente invention sera mieux comprise sur la base de la description qui va suivre et des dessins en annexe sur lesquels :
- la figure 1, est une représentation schématique, en coupe et de profil, d'une microbatterie sur un substrat de support, selon un mode de réalisation particulier de l'invention,
- la figure 2 est une représentation schématique, en trois dimensions, d'un substrat de support sur lequel sont disposés plusieurs dispositifs microélectroniques, selon un autre mode de réalisation particulier de l'invention,
- les figures 3A et 3B représentent le positionnement d'une couche de collage sur un substrat comportant des dispositifs microélectroniques, selon différents modes de réalisation du procédé de l'invention,
- les figures 4A et 4B représentent des dispositifs microélectroniques, disposés sur un substrat, encapsulés par une couche de collage et un capot de protection, selon différents modes de réalisation du procédé de l'invention,
- les figures 5A et 5B représentent un substrat, comprenant des dispositifs microélectroniques, encapsulés par une couche de collage et un capot de protection, et dont les faces latérales du substrat et du capot sont protégées par une couche de protection latérale, selon différents modes de réalisation du procédé de l'invention,
- les figures 6A et 6B représentent des systèmes miniaturisés facilement manipulables, comprenant des dispositifs microélectroniques, sur un substrat, encapsulés par un capot de protection, obtenus après amincissement du capot et du substrat, selon différents modes de réalisation du procédé de l'invention,
- les figures 7A et 7B représentent des clichés photographiques d'un assemblage comprenant un substrat sur lequel sont disposés des dispositifs microélectroniques, une couche de collage et un capot d'encapsulation, respectivement, avant et après l'étape d'amincissement,
- la figure 8 est un cliché obtenu au microscope de l'assemblage de la figure 7B après amincissement.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

### EXPOSÉ DÉTAILLÉ DE MODES DE RÉALISATION PARTICULIERS

Le procédé d'encapsulation d'au moins un composant microélectronique 300, par exemple, sensible à l'air (au dioxygène et à la vapeur d'eau), disposé sur un substrat de support 200, avec un capot d'encapsulation 400, va maintenant être décrit. Le procédé comprend les étapes successives suivantes :
a) fourniture d'un substrat de support 200, en un premier matériau, comprenant une première face principale 201 sur laquelle est disposée un dispositif microélectronique 300, une seconde face principale 202 opposée à la première face principale 201, et une face latérale,
b) dépôt d'une couche de collage 500, en un deuxième matériau, sur la première face 201 du substrat 200, autour du dispositif microélectronique 300,
c) positionnement d'un capot d'encapsulation 400, en un troisième matériau, comprenant une première face principale 401, une seconde face principale 402, opposée à la première face principale 401, et une face latérale, sur la couche de collage 500, de manière à fixer le capot d'encapsulation 400 sur le substrat de support 200, par l'intermédiaire de la couche de collage 500, et de manière à encapsuler le dispositif microélectronique 300,
d) dépôt d'une couche de protection latérale 600, en un quatrième matériau, à la fois sur la face latérale du substrat de support 200, sur la face latérale du capot d'encapsulation 400, sur le pourtour de la seconde face 402 du capot d'encapsulation 400 et sur le pourtour de la seconde face 202 du substrat de support 200, la couche de protection latérale 600 délimitant une zone protégée,
e) amincissement de la seconde face principale 202 du substrat de support 200 et/ou de la seconde face principale 402 du capot d'encapsulation 400 en dehors de la zone protégée, par gravure chimique.

A l'issue de l'étape e), le substrat de support 200 et/ou le capot d'encapsulation 400 ont été amincis, par exemple, jusqu'à une épaisseur inférieure à 200µm, de préférence, jusqu'à une épaisseur inférieure à 100µm tout en présentant une zone de préhension, non gravée, au niveau de la zone protégée par la couche de protection latérale, permettant de les manipuler facilement.

### Substrat de support 200 et capot d'encapsulation 400 :

Le substrat de support 200, aussi appelé substrat hôte ou substrat de support, fourni à l'étape a), est de préférence un substrat rigide.

Le capot d'encapsulation 400, fourni à l'étape c), est de préférence un capot d'encapsulation rigide.

Par exemple, le substrat rigide et/ou le capot d'encapsulation ont une épaisseur supérieure à 200µm, par exemple de 500µm à 1mm. Ils ont, par exemple, une épaisseur de 500µm.

Par rigide, nous entendons tout support aisément utilisable en microélectronique ayant une épaisseur supérieure à 200µm. Par exemple, le substrat 200 et/ou le capot d'encapsulation 400 ont initialement une épaisseur supérieure à 250µm, par exemple de 500µm. De préférence, le substrat 200 et le capot 400, fournis aux étapes a) et c), ont initialement une épaisseur supérieure à 200µm et sont tous les deux amincis lors de l'étape e) ou lors de l'étape e) et d'une étape ultérieure.

Le substrat 200 et le capot d'encapsulation 400 peuvent avoir des épaisseurs identiques ou différentes. L'épaisseur du capot peut être inférieure à celle du substrat 200 ou inversement. Cette éventuelle configuration permet de réaliser des dispositifs microélectroniques dont le capot d'encapsulation est plus fin que le substrat 200 ou inversement.

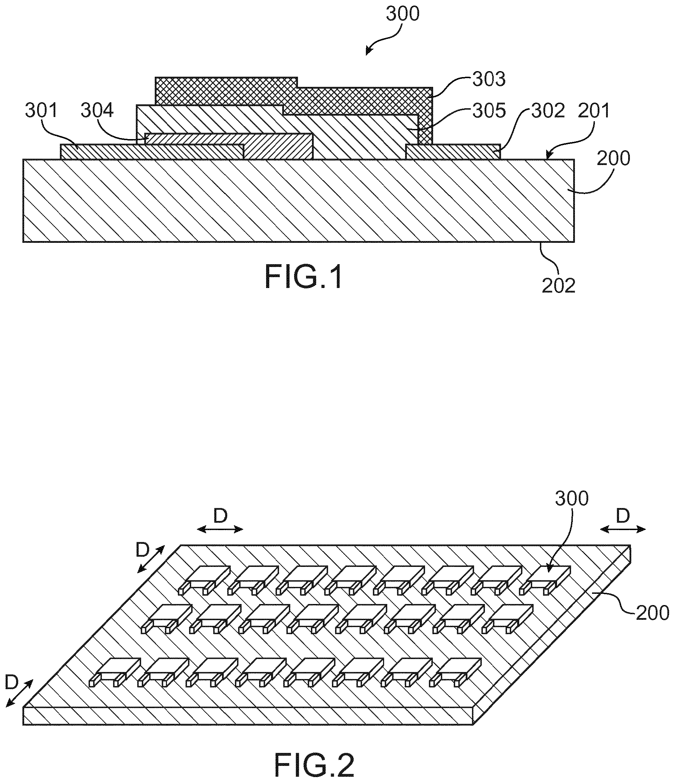

Comme représenté sur les figures 1 et 2, le substrat 200 comporte une première face principale 201, et une seconde face principale 202, opposée à la première face principale du substrat. La première face comprend au moins un composant microélectronique 300. Il s'agit de la face dite active. Le substrat comprend également une face latérale allant de la première face à la deuxième face.

Le capot 400 comprend une première face principale 401, et une seconde face principale 402, opposée à la première face principale 401, et une face latérale allant de la première face 401 à la seconde face 402. Sur la première face principale 401, peuvent être disposés des dispositifs électroniques identiques ou différents de ceux du substrat hôte.

Le substrat 200 et le capot d'encapsulation 400 peuvent avoir des formes géométriques identiques ou différentes. Il est possible par exemple d'utiliser des formats circulaires type wafers ou des formats feuilles, c'est-à-dire rectangulaires.

Le substrat de support 200 est en un matériau identique ou différent de celui du capot d'encapsulation.

Le substrat 200 et/ou le capot d'encapsulation 400 ont, avantageusement, les performances requises pour l'encapsulation des microbatteries au lithium. Ils sont élaborés en un matériau ayant des niveaux de barrière WVTR et OTR au plus, respectivement, de 10⁻⁴ g/m²/j et de 10⁻⁴ cm³/m²/j pour garantir des propriétés d'étanchéité suffisantes à la cellule de scellement vis-à-vis de l'air et de la vapeur d'eau.

Le substrat de support 200 et le capot d'encapsulation 400 peuvent être choisis parmi les verres, le silicium (monocristallin ou polycristallin), les céramiques, le mica, et le quartz. De préférence, ils sont en verre. Ils peuvent être en un verre de la même famille ou de familles différentes.

Les verres peuvent être des borosilicates (comme les D263^{®}LA, D263^{®}M, D263^{®}T, MEMpax^{®} ou encore le Borofloat^{®} commercialisés par la société SCHOTT^{®}), des dérivés de borosilicates comme les verres alkali-free borosilicates (AF32^{®}, AF45, Corning^{®}Willow....) ou encore des verres alkaline earth boro-aluminosilcates (Corning Lotus^{™}, EAGLE XG^{®}...).

De préférence, le capot 400 est transparent aux longueurs d'onde des lasers classiquement utilisés pour figer des cordons de scellement (typiquement pour des cordons de scellement en pâte de verre, autour de 940nm). Par transparent, on entend que le capot laisse passer au moins 50% de la lumière émise par le laser de manière à pouvoir chauffer le cordon de scellement à travers le capot 400.

De préférence, le substrat de support 200 et le capot d'encapsulation 400 ont des épaisseurs identiques et sont en un même matériau.

### Dispositif microélectronique 300 à encapsuler :

Le procédé permet d'encapsuler simultanément un dispositif ou plusieurs dispositifs microélectroniques 300. Le dispositif microélectronique 300, ou composant microélectronique, a une épaisseur allant de 5µm à 30µm, et de préférence de 10 à 15µm.

Sur la première face principale 201 du substrat 200, peuvent être disposés un ou plusieurs dispositifs électroniques 300 de même nature ou de natures différentes. Cette configuration offre la possibilité de réaliser des empilements fonctionnels par intégration 3D.

Le capot d'encapsulation 400 peut être un élément passif ou actif, i.e. la première face 401 du capot 400 peut comporter des dispositifs microélectroniques 300 de même nature ou de natures différentes de celles du substrat 200, pouvant remplir d'autres fonctionnalités.

Le substrat de support 200 et/ou le capot d'encapsulation 400 peuvent comporter un ou plusieurs dispositifs microélectroniques 300 pour multiplier les performances électrochimiques par une mise en parallèle ou en série des dispositifs microélectroniques. Les dispositifs microélectroniques peuvent être, par exemple, choisis parmi les microbatteries, les capacités, les supra-capacités, les dispositifs photovoltaïques, les transistors, les antennes ou tout autre dispositif jugé nécessaire pour la réalisation d'objets connectés.

Avantageusement, les dispositifs microélectroniques du substrat et du capot sont positionnés en vis-à-vis afin de pouvoir les associer selon une approche d'empilement 3D.

Par composant microélectronique 300, on entend, par exemple, un MEMS (microsystème électromécanique), un MOEMS (microsystème opto-électromécanique), ou encore un micro-détecteur infrarouge, ou même un transistor. Plus généralement, par composant microélectronique, on entend tout dispositif destiné à être encapsulé sous atmosphère contrôlée.

Par la suite, même si la description fait en particulier référence à une microbatterie, et plus particulièrement à une microbatterie au lithium, l'invention est transposable à tout composant microélectronique nécessitant une protection vis-à-vis des oxydants. Il peut s'agir, par exemple d'un empilement capacitif ou d'un composant électrochrome.

Le composant microélectronique 300, ici la microbatterie, est disposée sur une des faces 201 (première face principale) du substrat 200. Comme représenté sur la figure 1, la microbatterie comprend des collecteurs de courant cathodique 301 et anodique 302, disposés sur le substrat 200. Deux couches actives, l'une formant l'électrode négative 303, et l'autre formant l'électrode positive 304, sont séparées par une couche d'électrolyte 305. Chaque couche active 303, 304 est en contact avec l'un des collecteurs de courant 301, 302.

Les collecteurs de courant 301, 302 sont, avantageusement, métalliques. A titre illustratif, ils peuvent être en titane, or, aluminium, platine, ou en tungstène.

L'électrode positive 304 (cathode) est en un matériau ayant une bonne conductivité électronique et ionique (par exemple TiOS, TiS₂, LiTiOS, LiTiS₂, LiCoO₂, V₂O₅...). On choisira de préférence une électrode positive en oxyde de cobalt. Ce type de cathode est considéré comme l'une des couches les plus performantes pour les microbatteries et en même temps les plus contraintes lors des étapes de réalisation. En effet, les contraintes mécaniques engendrées après formation de la couche cathodique (Coefficient d'expansion thermique entre 10×10⁻⁶/°C et 15×10⁻⁶/°C et un module de Young entre 100 et 500 GPa) peuvent influer sur le comportement des substrats rigides une fois amincis.

L'électrolyte 305 est un isolant électronique avec une forte conductivité ionique (par exemple LiPON, LiPONB, LiSiCON...).

L'électrode négative 303 (anode) est une couche qui peut être du lithium métallique ou un matériau lithié.

Optionnellement et selon les configurations, les couches actives peuvent être protégées par un système d'encapsulation primaire, non représenté, comprenant une ou plusieurs couches barrières élémentaires dont le rôle principal est de garantir une intégrité des dispositifs microbatteries pendant les différentes phases du procédé.

La microbatterie sera réalisée par les techniques connues de l'homme du métier.

Les dispositifs microélectroniques 300 sont positionnés en dehors du contour périphérique du substrat de support et/ou du capot d'encapsulation pour les protéger, lors de l'étape de gravure. Avantageusement, cette distance géométrique D par rapport au bord du substrat de support et/ou du capot d'encapsulation sera choisie de manière à être au moins égal au double de l'épaisseur initiale du substrat et/ou du capot. Par exemple, elle est de 5mm. Cette distance est représentée par la lettre D sur les figures 2 à 5B.

### Couche de collage 500 :

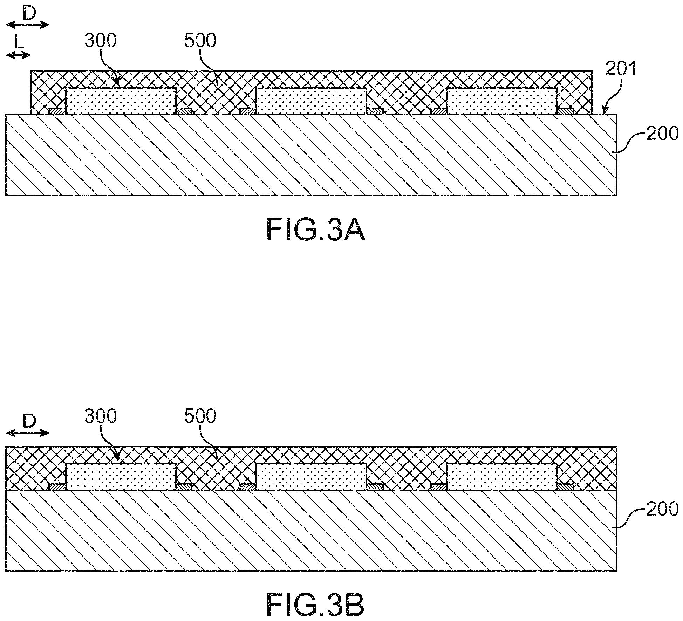

Comme représenté sur les figures 3A et 3B, lors de l'étape b), une couche de collage 500 est positionnée sur la première face 201 du substrat de support 200, de part et d'autre du dispositif microélectronique 300.

La couche de collage 500 entoure le composant microélectronique 300, de manière à former, après le report du capot d'encapsulation 400 une barrière de protection autour du composant microélectronique 300.

De façon avantageuse, la couche de collage 500 permet, en outre, d'absorber mécaniquement les mouvements d'expansion volumique engendrés par le fonctionnement de la microbatterie correspondant à l'insertion/désinsertion du lithium lors des cycles de charge et de décharge.

De façon avantageuse, elle protège les microbatteries des oxydants présents dans l'air (oxygène et vapeur d'eau).

Elle peut également avoir des propriétés de résistance par rapport à la gravure, et notamment par rapport à la solution de gravure chimique, pour empêcher le risque d'infiltration des produits chimiques vers les couches actives lors de l'étape d'amincissement.

La couche de collage 500 a une épaisseur supérieure ou égale à celle du ou des dispositifs microélectroniques 300 à encapsuler.

Selon un premier mode de réalisation, représenté sur la figure 3A, la couche de collage 500 recouvre la première face 201 du substrat 200, à l'exception du pourtour de la première face 201. On positionnera, avantageusement, la couche de collage 500 a une distance géométrique, notée L, par rapport au bord du substrat et/ou du capot. La valeur L est telle que L<D. La valeur L est au moins égale à l'épaisseur du substrat rigide et/ou du capot rigide avant amincissement. Par exemple, la valeur de la distance L est de 3mm.

Selon un deuxième mode de réalisation, représenté sur la figure 3B, la couche de collage 500 recouvre complètement la première face 201 du substrat 200. Par complètement, on entend au moins 90% de la surface totale de la première face 201 du substrat 200. La couche de collage 500 recouvre également le pourtour de la première face 201.

Dans ces différents modes de réalisation, lors de l'étape b), la couche de collage 500 peut être étalée sur la surface du substrat 200 comportant le dispositif microélectronique, par toute technique adaptée. Différentes techniques de dépôt peuvent être utilisées pour déposer la couche de collage 500. Pour les dépôts en voie liquide, pour former des couches de collage déposées pleine plaque, on privilégiera la technique de dépôt à la tournette (« spin coating »). La solution aura, avantageusement, une viscosité de moins de 1000cPs. En modifiant la vitesse et le temps de rotation de la tournette, on pourra faire varier l'épaisseur de la couche de collage 500. Par exemple, dans le cas d'une couche en époxyde OG198-54, l'épaisseur totale pourra varier de 1 à 25 µm. Un masque pourra être utilisé pour protéger le pourtour de la première face 201 du substrat 200.

La couche de collage 500 est, de préférence, obtenue par polymérisation d'un polymère photopolymérisable, par exemple sous UV, ou thermodurcissable. Il peut s'agir d'un polymère à faible viscosité (par exemple, ayant une viscosité inférieure à 2000 cPs).

Le polymère est de la famille des époxydes, des éthers, des silicones, des acrylates ou d'un de leurs copolymères. On pourra choisir les polymères commerciaux de la série Epo-Tek réticulés par UV ou par voie thermique comme les produits (OG198-54, UD1355, OG653, UG1192, T7110, H70E...).

Alternativement, la couche de collage 500 peut être un film adhésif. Le film adhésif est laminé sur le substrat. Le film adhésif sera choisi en fonction de ses propriétés de collage, de conformabilité, d'isolation électrique et/ou de compatibilité chimique avec les couches actives de la microbatterie. Il peut être sensible à la pression (« Pressure sensitive Adhesive »), à la température ou aux rayons UV. Il peut être obtenu à partir de films polymères à base d'acrylique, de silicone, de caoutchouc ou d'un de leurs mélanges. A titre indicatif et non exhaustif, on pourra utiliser les adhésifs isolants commercialisés par Tesa, Henkel, 3M, Norland ou Novagard. Par exemple, on utilisera une couche d'adhésif Tesa61562 d'une épaisseur de 25µm commercialisé par la société Tesa pour réaliser la solidarisation du substrat et du capot. La solidarisation peut être réalisée par un procédé de laminage à une température de 90°C avec une pression supérieure à 1 bar et une vitesse inférieure à 3 m/mn.

Un ou plusieurs adhésifs peuvent être utilisés pour former la couche de collage 500.

La couche de collage 500 peut également comprendre des inclusions particulaires et/ou des absorbeurs (getters) d'oxygène et d'eau pour améliorer leurs étanchéités.

La couche de collage 500, déposée à l'étape b), peut être structurée par des techniques de photolithographie ou de gravure laser.

Selon un autre mode de réalisation, non représenté, la couche de collage 500 peut recouvrir uniquement partiellement la première face 201 du substrat 200. De préférence, la couche de collage 500 forme un cordon de scellement autour du dispositif microélectronique.

Le cordon de scellement 500 est positionné de telle sorte qu'une fois que le capot 400 sera reporté sur le substrat 200, le cordon 500 entoure le composant microélectronique 300 à encapsuler pour l'isoler de l'atmosphère. Dans le cas de microbatteries 300, le cordon de scellement 500 est, avantageusement, disposé au niveau des collecteurs de courant 301, 302 pour gagner de la place et faciliter la miniaturisation.

Le cordon de scellement 500 est électriquement non conducteur.

Le cordon de scellement 500 peut être en un matériau polymère.

Le cordon de scellement 500 est, avantageusement, réalisé à partir d'une pâte de verre. Les pâtes de verre comprennent des particules de verre dispersées dans un liant organique. Par exemple, une pâte de verre peut contenir au moins 70% massique de particules de SiO₂. Le liant organique est détruit en chauffant la pâte de verre. Les pâtes de verre peuvent être vitrifiées à des températures allant de 300°C à 400°C. Les pâtes de verre vitrifiées forment les soudures. Elles maintiennent mécaniquement le capot 400 au substrat 200. Elles sont également étanches vis-à-vis des oxydants de l'air.

Les cordons en verre fritté présentent généralement des propriétés barrières à l'air nettement supérieures à celles des colles.

A titre d'exemple, les pâtes de verre commercialisées par Namics sous la référence DM2700P/H848, commercialisées par AGC (Asahi Glass Company) sous les références 4290D1, 5115HT1, TNS062-Z27-TP12, 5290D1 ou encore commercialisées par Corning sous la référence Vita^{™} peuvent être envisagées pour la réalisation du cordon de scellement 500. Ces pâtes de verre sont compatibles avec les matériaux en verre choisis pour le substrat 200 et/ou pour le capot 400 de fermeture et d'encapsulation.

De préférence, le cordon 500 est élaboré à partir de la pâte DM2700P/H848. En plus de ses propriétés intrinsèques barrières vis-à-vis des espèces oxydantes (valeurs de WVTR et de OTR de l'ordre de de 10⁻⁶ gm⁻²j⁻¹ et de 10⁻⁶ cm³/m²/j), ce produit possède de bonnes propriétés thermiques (CET de 7,7×10⁻⁶ K⁻¹ à 20°C) très proches des matériaux en verre (CET de 7,2×10⁻⁶ K⁻¹ à 20°C). En outre, ce produit peut être scellé avec des temps relativement courts sous irradiation laser (de l'ordre de 60 secondes), ce qui limite les risques de propagation de chaleur durant l'étape de scellement.

Alternativement, d'autres produits commercialisés par AGC sous la référence 5115HT1 ou par Corning sous la référence Vita^{™} peuvent être utilisés dans la réalisation du cordon de scellement 500.

Le cordon de scellement 500 a une épaisseur qui peut varier de quelques microns à une centaine de microns. Par épaisseur, on entend la dimension perpendiculaire à l'empilement substrat/capot. Son épaisseur sera choisie par l'homme du métier afin de créer, une fois le procédé d'encapsulation achevé, une cavité entre le substrat 200 et le capot d'encapsulation 400 suffisante pour ne pas perturber les cycles de charge et de décharge des microbatteries. Ces cycles, qui correspondent à un phénomène d'insertion/désinsertion du lithium entre les deux électrodes, se traduisent généralement par des phénomènes d'expansion volumique des électrodes. Il est donc primordial de former une cavité suffisamment haute pour un libre mouvement vertical des électrodes. La hauteur d'une telle cavité dépend de la différence de hauteur entre l'épaisseur du cordon 500 et celle de l'empilement des couches actives de la batterie 300. Typiquement, la valeur minimale de cette hauteur est fixée autour de 5% de la valeur de l'épaisseur totale de la microbatterie 300. La largeur et l'épaisseur du cordon de scellement 500 sont optimisées en fonction de la taille des éléments à protéger afin de réduire efficacement l'encombrement de la surface des cordons 500 par rapport à la surface totale du dispositif microbatterie. La largeur du cordon de scellement 500 sera d'au moins 100µm, dans le cas d'un substrat 200 avec des microbatteries 300. De telles dimensions satisfont aux propriétés d'étanchéité et de tenue mécanique requises. On utilisera, par exemple, une épaisseur de 50µm et une largeur de 100µm.

Le cordon 500 peut être formé sur la première face 201 du substrat 200 et/ou sur la première face 401 du capot d'encapsulation 400 en utilisant toute technique adaptée (dispense, par exemple par application au pinceau, à la brosse, sérigraphie ou autres).

Après l'étape de dépôt de la pâte de verre, le cordon de scellement 500 obtenu est, avantageusement, vitrifié en réalisant un traitement thermique. La température du traitement est, par exemple, de 100°C à 160°C, par exemple de l'ordre de 150°C. La durée du traitement va, par exemple, de quelques minutes à une heure, par exemple de l'ordre de 30 minutes. Ce traitement thermique permet, avantageusement, de dégazer les solvants présents initialement dans la pâte de verre (10 à 15% en volume).

### Positionnement du capot d'encapsulation 400 :

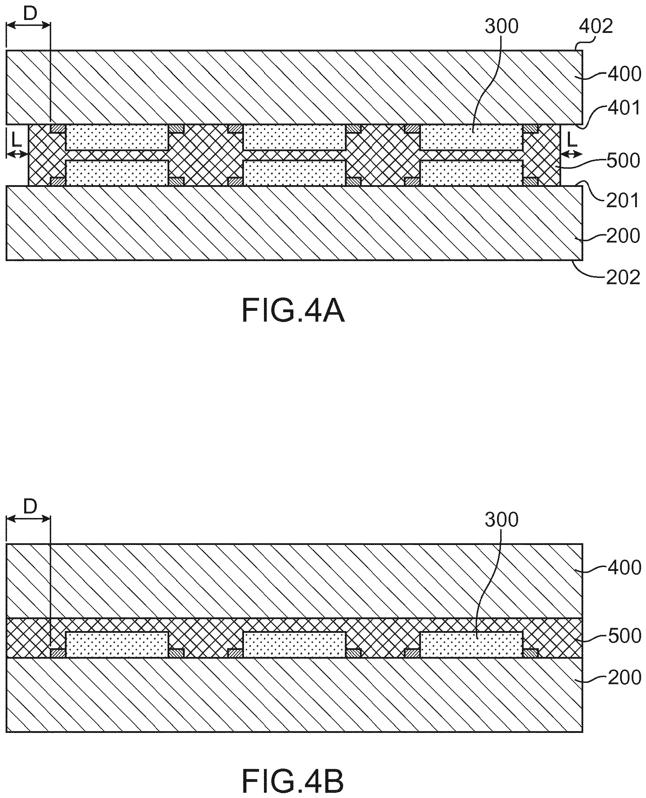

Comme représenté sur les figures 4A et 4B, lors de l'étape c), le capot d'encapsulation 400 est positionné au-dessus du substrat 200.

Une force F (de quelques newtons, par exemple d'environ 2 N) peut être appliquée lors du positionnement du capot 400 pour garantir un contact homogène entre la couche de collage 500 et le substrat de support 200 et/ou le capot d'encapsulation 400.

Une irradiation avec une source ultra-violette et/ou un chauffage thermique peut être utilisé pour consolider et figer la couche de collage 500, permettant ainsi la fixation mécanique du substrat de support 200 au capot 400 par l'intermédiaire de la couche de collage 500.

Par exemple, la solidarisation de la structure de base est assurée par une insolation UV à travers le capot d'encapsulation en utilisant une dose d'environ 100mWatt/cm² dans la gamme de longueur d'onde entre 280nm-800nm pendant 2mn. La réticulation UV peut être complétée par un recuit thermique, par exemple, d'une durée de 20mn et à une température de 100°C.

Les cordons de scellement sont, avantageusement, exposés à un rayonnement laser à travers la face supérieure 402 du capot d'encapsulation 400 à l'aide d'un rayonnement laser pour chauffer localement les cordons de scellement. Le chauffage par irradiation laser est particulièrement avantageux puisqu'il ne nécessite pas de chauffer l'ensemble du substrat 200 et du capot 400. Il permet de chauffer localement les cordons 500 jusqu'à plus de 300°C, par exemple de 300°C à 400°C de manière à les vitrifier et à former les soudures, nécessaires au scellement. Le capot 400 est ainsi scellé de façon permanente sur le substrat 200 contenant les dispositifs 300.

On choisira avantageusement une fibre laser pour localiser encore plus le rayonnement.

L'augmentation de la température rend les matériaux des cordons 500 plus aisément déformables par effet de fusion, et augmente la surface de contact entre le cordon 500 et le capot 400 ou le substrat 200. La température peut atteindre, localement, plus de 500°C lors de l'irradiation laser.

Les caractéristiques principales des lasers seront choisies par l'homme du métier en fonction de la nature de la pâte de verre employée pour le cordon 500 et les propriétés optiques du capot 400. Plus particulièrement, la gamme de longueurs d'onde de lasers disponible va de l'infrarouge (lasers CO₂, Nd:YAG, etc.) à la lumière ultraviolette (laser Excimer et des harmoniques de Nd: YAG). Ceci offre la possibilité de choisir la longueur d'onde la plus appropriée pour garantir un collage efficace des pâtes de verre. Par exemple, un rayonnement à une longueur d'onde se situant dans le domaine du proche infrarouge, typiquement à 940 nm, peut être choisi.

Le cordon 500 peut être soumis à une illumination laser pendant une durée allant de quelques dizaines de secondes à quelques centaines de secondes.

Le scellement peut être réalisé pas balayage laser. Le faisceau peut se déplacer à une vitesse de quelques mm/s, par exemple de l'ordre de 2mm/s.

Par exemple, une illumination laser à une puissance de 80W pendant 60s, avec un déplacement de 2mm/s est suffisante pour engendrer l'abrasion du cordon 500 permettant de sceller de façon permanente le capot d'encapsulation avec le substrat rigide contenant les dispositifs à encapsuler.

Cette étape permet de vitrifier et de souder les cordons de scellement, pour assurer la cohésion mécanique et l'étanchéité de l'encapsulation.

Le procédé est, avantageusement, réalisé dans un environnement inerte, de manière à remplir les cavités, délimitées par le substrat 200, le capot 400 et le cordon de scellement 500, avec un gaz inerte. Des getters peuvent également être utilisés pour piéger l'oxygène et la vapeur d'eau. Le procédé est, par exemple, réalisé dans une boîte à gants.

### Couche de protection latérale 600 :

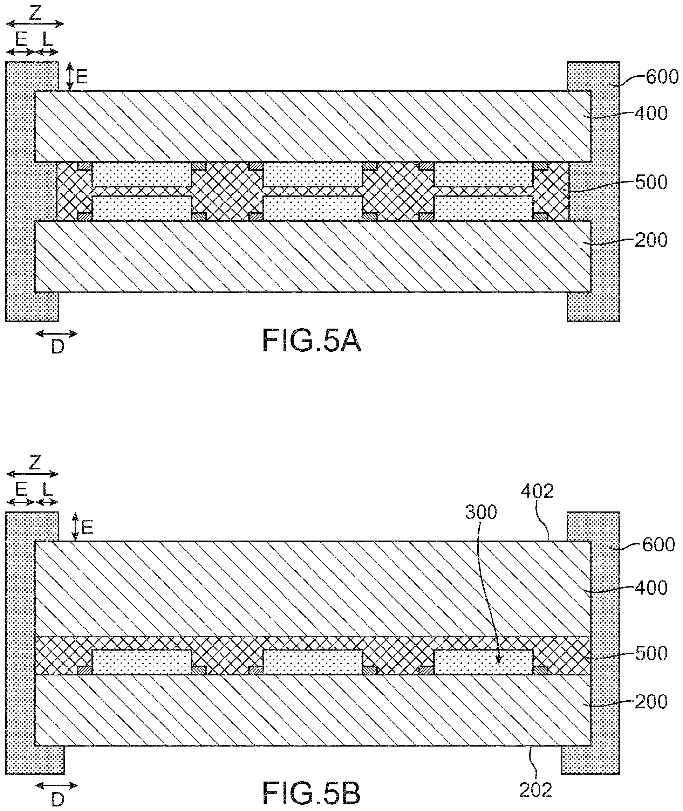

Comme représenté sur les figures 5A et 5B, une couche de protection latérale 600 est déposée, lors de l'étape d).

La couche de protection latérale 600 couvre de façon continue les faces latérales du substrat de support 200 et du capot d'encapsulation 400. De préférence, elle recouvre également les faces latérales de la couche de collage 500.

La couche de protection latérale 600 masque le pourtour de la seconde face 202 du substrat de support 200 et/ou de la seconde face 402 du capot d'encapsulation 400. La couche de protection latérale 600 est continue depuis le pourtour de la seconde face 402 du capot d'encapsulation 400 jusqu'au pourtour de la seconde face 202 du substrat de support 200.

La zone de masquage protège le pourtour de ces éléments lors de l'étape de gravure. Seules les zones non protégées seront gravées. Le masquage du pourtour de la structure par la couche de protection latérale 600 permet de créer une zone de préhension pour les opérations de manipulation et de transfert pendant et après la fin du procédé d'amincissement.

Avantageusement, la couche de protection latérale 600 permet de consolider mécaniquement la structure.

Comme représenté sur la figure 5, le symbole Z défini la largeur de son étalement latéral au niveau des faces passives du substrat et du capot et le symbole E définit son épaisseur effective.

La zone de masquage est, avantageusement, positionnée en dehors du périmètre des dispositifs microélectroniques 300. Avantageusement, la valeur de Z est inférieure à la valeur de D afin de préserver les dispositifs microélectroniques lors des opérations de « back-end » comme par exemple lors de l'étape de découpe (« singulation »). La valeur E peut aller jusqu'à 1cm.

La couche de protection latérale 600 est, de préférence, en un matériau polymère judicieusement choisi en raison de sa résistance chimique par rapport à l'étape de gravure. La nature de la couche de protection latérale 600 sera choisie par l'homme du métier en fonction de la nature du substrat de support et/ou du capot d'encapsulation. La couche de protection latérale est en un matériau résistant à la gravure de l'un de ces éléments.

La couche de protection latérale 600 est, par exemple, en un polymère choisi parmi les époxydes, les silicones, ou encore il peut s'agir d'un adhésif PSA, ou d'un adhésif UV. On pourra également choisir du polyéthylène téréphtalate (PET) ou du parylène. Il est également possible d'utiliser un film en alumine, en oxyde de silicium ou en nitrure de silicium.

La couche de protection latérale 600 peut être réalisée par un dépôt d'une ou plusieurs couches physiques de même nature ou de natures différentes. La couche de protection peut également être obtenue par un traitement de surface, comme par exemple un dépôt physique de couches minces, ayant de préférence une épaisseur de l'ordre de 100µm. On déposera, par exemple, un polymère liquide sur la bordure et les flancs de la structure définis par le substrat de support, le capot d'encapsulation et le film adhésif.

### Amincissement du substrat de support 200 et/ou du capot d'encapsulation 400 :

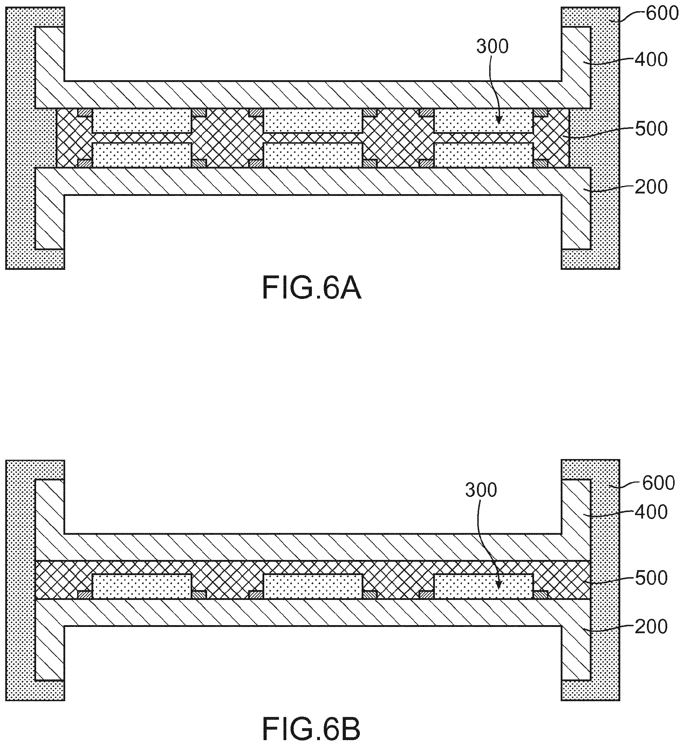

L'étape d'amincissement, réalisée lors de l'étape d), permet d'obtenir un capot et/ou un substrat ayant une épaisseur et une rugosité contrôlées (figures 6A et 6B).

L'amincissement est réalisé par gravure chimique (ou rectification chimique). L'un des avantages majeurs de la rectification chimique par rapport à la rectification mécanique réside dans le faible stress engendré par l'amincissement chimique.

L'étape de gravure permet de graver la partie de la seconde face 202 du substrat de support 200 et/ou la partie de la seconde face 402 du capot d'encapsulation 400 qui ne sont pas protégées par la couche de protection latérale 600. Seule la partie centrale est gravée. A l'issue de l'étape de gravure, le substrat et/ou le capot présente une zone périphérique plus épaisse que la zone centrale. La zone périphérique « surélevée » permet de manipuler facilement l'assemblage. L'épaisseur de la zone périphérique correspond à l'épaisseur initiale de l'élément. Par exemple, après gravure, la zone périphérique présente une épaisseur supérieure à 200µm, par exemple, une épaisseur de 500µm alors que la zone centrale présente une épaisseur inférieure à 100µm.

La solution utilisée pour la gravure chimique sera choisie par l'homme du métier de manière à être adaptée pour graver la seconde face 402 capot 400 et/ou la seconde face 202 du substrat 200.

Par exemple, pour graver des éléments en silicium, il s'agira d'une solution de nature basique. La solution de gravure peut être de l'hydroxyde de potassium (KOH) à une température de 80°C permettant une vitesse de gravure de l'ordre de 1,5 µm/mn. Dans le cas de l'utilisation d'une solution basique, on privilégiera des matériaux de type polysiloxanes (silicones) pour le collage de la structure de base pour leur résistance aux solutions basiques.

Pour graver des éléments en verre, on choisira une gravure de nature acide. Il peut s'agir d'une solution de gravure très concentrée en acide fluorhydrique HF (49%), d'un mélange HF avec de l'acide chlorhydrique HCl, ou encore d'un mélange entre l'HF, l'eau et de l'acide nitrique. A titre d'exemple dans le cas d'un verre alkali-free, une solution chimique comprenant un mélange équilibré avec 10% d'acide chlorhydrique (HCl) et 2% d'acide fluorhydrique (HF) permet d'avoir une vitesse de gravure standard (25°C) jusqu'à 1µm/min. Cette valeur peut être de l'ordre de 2µm/min pour une solution de gravure chauffée à 35°C. Les mélanges peuvent être ajustés afin d'augmenter la vitesse de gravure, ainsi un mélange de 10%HF et 37%HCl permet d'atteindre des vitesses de 4µm/min. On pourra atteindre des valeurs de vitesse de gravure situées entre 20 et 30µm/min en ajustant les proportions de chaque constituant et/ou en augmentant la température.

De façon générale, les solutions de gravure peuvent être adaptées en température et en composition en fonction des matériaux à graver (silicium, verre), des épaisseurs finales recherchées et/ou des rugosités de surface souhaitées. Il est possible d'envisager une gravure chimique dans des solutions, appelées bains, en mode batch (trempage) ou par jet (douchette) en série.

Les liquides ont la composition chimique adaptée à la nature des matériaux employés dans la fabrication des substrats et des capots. Cette opération peut être réalisée de façon individuelle (une seule structure par défilement en ligne ou immersion en bain) ou de façon collective par lot de plusieurs structures à la fois.

L'étape de gravure est, avantageusement, suivie par une étape de rinçage à l'eau déionisée et par un séchage, par exemple, sous un flux d'air ou de gaz neutre. Ces séquences d'opérations rinçage/séchage peuvent être répétées de nombreuses fois jusqu'à élimination totale des résidus du mélange acide employé dans la gravure.

Lorsque le substrat de support 200 et le capot d'encapsulation 400 sont en un même matériau, par exemple, en verre, une seule solution de gravure peut être utilisée pour les graver simultanément.

Lorsque le substrat de support 200 et le capot d'encapsulation 400 sont en deux matériaux différents, par exemple, l'un en verre et l'autre en silicium, deux solutions de gravure différentes peuvent être utilisées successivement.

L'homme du métier choisira pour la couche de protection latérale 600 un matériau résistant aux différentes solutions de gravure utilisées lors du procédé.

Formation des contacts électriques et/ou découpe du substrat et/ou du capot :

Après l'étape d'amincissement, une étape ultérieure dans laquelle les contacts sont libérés et/ou dans laquelle les différents dispositifs microélectroniques sont séparés en élément unitaire est réalisée.

Dans un premier temps, des ouvertures sont réalisées dans le capot d'encapsulation. Cette étape peut être réalisée par toute méthode de découpe connue de l'homme du métier et adaptée aux matériaux des substrats et/ou capots. On pourra utiliser notamment une découpe mécanique à scie (« sawing ») ou encore une découpe laser (laser CO₂, laser YAG, laser picoseconde, laser femtoseconde ou laser excimer). Les ouvertures ont, par exemple, un diamètre de 100µm à 500µm.

Les ouvertures peuvent ensuite être remplies avec un élément électriquement conducteur, tel qu'un métal ou un alliage de métal, ou encore une résine électriquement conductrice. Par exemple, on pourra choisir une résine à base de polymères électriquement conducteurs, telle que la résine E4110 commercialisée par la société Epo-Tek. Un traitement thermique peut ensuite être réalisé.

Il est également possible de laminer un film électriquement conducteur ou d'électrodéposer des couches électriquement conductrices dans les ouvertures.

Finalement, les dispositifs microélectroniques sont séparés de façon individuelle pour obtenir des éléments unitaires.

Le procédé de la présente invention permet d'encapsuler de façon groupée simultanée plusieurs dispositifs microélectroniques disposés sur un même substrat ou sur un substrat et sur un capot et, plus particulièrement, il permet d'obtenir des structures miniaturisées comprenant un substrat et/ou un capot fin ou ultrafin, facilement manipulables.

### Exemple illustratif et non limitatif d'un mode de réalisation de l'invention :

Cet exemple concerne l'amincissement en une seule étape d'un capot d'encapsulation 400 et d'un substrat 200 rigides en verre comprenant des microbatteries au lithium 300.

### Etape 1 : Réalisation de l'empilement des microbatteries :

Plusieurs microbatteries au lithium 300 ont été réalisées sur un substrat 200 en verre AF32 de 500µm d'épaisseur. La variation de l'épaisseur totale (ou TTV pour « Total Thickness Variation ») est de 1µm. Les microbatteries ont une épaisseur de 20µm environ. Les microbatteries sont réalisées par des techniques connues de l'homme du métier. Les microbatteries sont positionnées à une distance D par rapport au bord du substrat de 5mm.

Les collecteurs de courant sont tout d'abord déposés sur le substrat. Puis sont successivement déposés la cathode, l'électrolyte et l'anode.

La cathode est en oxyde de cobalt (LiCoO₂) d'une épaisseur de 20µm obtenue à partir d'un dépôt sous vide (PVD pour « Physical Vapor Deposition ») suivie d'un recuit thermique à 600°C pendant 10h.

L'électrolyte est une couche de 2µm d'épaisseur en LiPON.

L'électrode négative est une couche en lithium métal d'une épaisseur de 2µm.

### Etape 2 : Dépôt de la couche de collage 500 et positionnement du capot d'encapsulation 400 :

Un film adhésif est positionné sur la face active du substrat. Il est positionné à une distance L par rapport au bord du substrat de 3mm. Le film adhésif est du Tesa61562 d'une épaisseur de 25µm commercialisés par la société Tesa. Le film a été laminé à une température de 90°C, à une pression supérieure à 1 bar et une vitesse inférieure à 3 m/mn.

Un capot d'encapsulation, en verre, est positionné sur la couche de collage.

Une fois, le capot d'encapsulation positionné, une force modérée F (de l'ordre de 2N) est appliquée sur le capot d'encapsulation afin de garantir un contact homogène entre la couche de collage et le substrat contenant les dispositifs microbatteries.

### Etape 3 : Dépôt de la couche de protection latérale 600 :

La couche de protection latérale 600 est obtenue en utilisant la solution NOA61 commercialisé par la société Norland. La solution a une viscosité de 300 CPs. La solution est déposée à une pression d'environ 2 bars. Puis un pré-recuit UV est réalisé pendant 5 s à une puissance de 100 Watts en utilisant une lampe UV dans la gamme 315nm-550nm. Ce pré-recuit permet de pré-réticulé et de fixer le polymère sur le substrat. Le durcissement du polymère est effectué lors d'une deuxième opération d'exposition UV pendant 10 minutes à une puissance de 100 Watts. Optionnellement, la réticulation est complétée par un recuit thermique à 50°C pendant 10h.

La largeur Z et l'épaisseur E du polymère de protection latérale sont respectivement de l'ordre de 4mm et de 6mm.

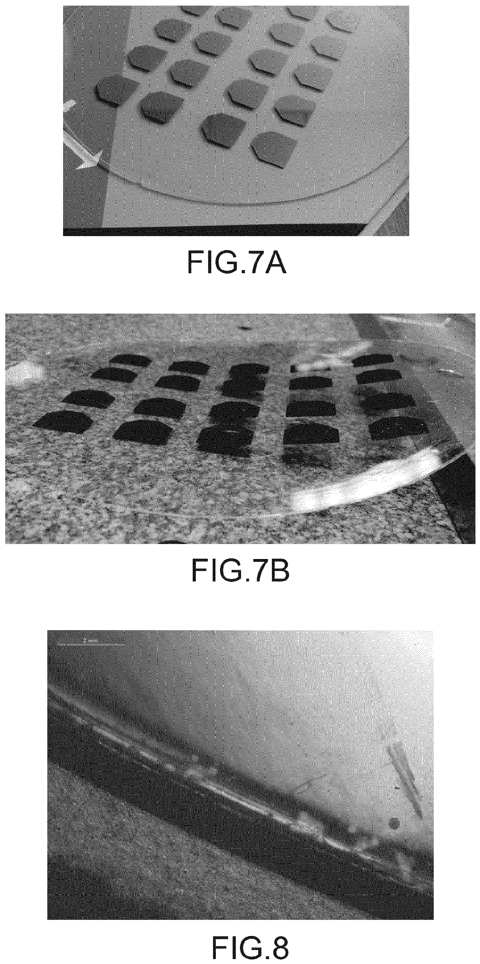

L'ensemble est représenté sur la figure 7A.

### Etape 4 : Amincissement chimique du substrat 200 et du capot 400 :

Cette étape est réalisée en trempant la structure dans un bain chimique acide (pH<7) constitué de 10% d'HCl et de 37% d'HF. Le bain est chauffé à une température de 25°C. La gravure est réalisée pendant une durée d'environ 90min afin de ramener l'épaisseur initiale du substrat et du capot de 500µm à 50µm, à l'exception des zones protégées par la couche de protection latérale. L'épaisseur du verre du pourtour masqué par le polymère de protection est restée inchangée (500µm) et l'intégrité mécanique de la zone de préhension est entièrement préservée, autorisant ainsi des opérations de manipulation et de transfert de la structure (figures 7B et 8).

La structure amincie est ensuite soumise à des opérations de rinçage à l'eau DI et de séchage sous air.

Différentes étapes de « back-end » relatives à l'accomplissement des procédés microélectroniques comme les opérations de découpe, de singulation, de libération de contacts électriques ou d'intégration peuvent ensuite être réalisées.

### Etape 5 : Découpe de la structure de base :

La réalisation des ouvertures ainsi que la découpe en composant unitaire sont réalisées par 10 passages d'un laser picoseconde dans le visible (530 nm) à une énergie de 50 µJ.

Les ouvertures de 300µm de diamètre sont remplies par une résine conductrice E4110 commercialisé par la société Epo-Tek. Un traitement thermique à 150°C d'une durée de 15 minutes est réalisé.

Les dispositifs microélectroniques sont ensuite séparés.

## Revendications

1. Procédé d'encapsulation d'un dispositif microélectronique (300), disposé sur un substrat de support (200), avec un capot d'encapsulation (400) comprenant les étapes successives suivantes :
a) fourniture d'un substrat de support (200), en un premier matériau, comprenant une première face principale (201) sur laquelle est disposée un dispositif microélectronique (300), une seconde face principale (202) opposée à la première face principale (201), et une face latérale,
b) dépôt d'une couche de collage (500), en un deuxième matériau, sur la première face (201) du substrat (200), autour du dispositif microélectronique (300),
c) positionnement d'un capot d'encapsulation (400), en un troisième matériau, comprenant une première face principale (401), une seconde face principale (402), opposée à la première face principale (401), et une face latérale, sur la couche de collage (500), de manière à fixer le capot d'encapsulation (400) sur le substrat de support (200), et de manière à encapsuler le dispositif microélectronique (300),
d) dépôt d'une couche de protection latérale (600) en un quatrième matériau sur la face latérale du substrat de support (200), sur la face latérale du capot d'encapsulation (400), sur le pourtour de la seconde face (402) du capot d'encapsulation (400), et sur le pourtour de la seconde face (202) du substrat de support (200), la couche de protection latérale (600) délimitant une zone protégée,
e) amincissement de la seconde face principale (202) du substrat de support (200) et/ou de la seconde face principale (402) du capot d'encapsulation (400), en dehors de la zone protégée, par gravure chimique.

2. Procédé selon la revendication 1, **caractérisé en ce que** le premier matériau et/ou le troisième matériau sont choisis parmi le verre et le silicium.

3. Procédé selon l'une quelconque des revendications 1 et 2, **caractérisé en ce que** le premier matériau et le troisième matériau sont identiques ou différents.

4. Procédé selon l'une quelconque des revendications 1 à 3, **caractérisé en ce que** lors de l'étape b), la couche de collage (300) recouvre totalement le dispositif microélectronique (300).

5. Procédé selon l'une quelconque des revendications 1 à 3, **caractérisé en ce que** lors de l'étape b), la couche de collage (600) forme un cordon de scellement autour du dispositif microélectronique (300).

6. Procédé selon l'une quelconque des revendications précédentes, **caractérisé en ce que** le deuxième matériau et/ou le quatrième matériau est un matériau polymère choisi parmi les époxydes, les éthers, les polysiloxanes, les acryliques, un de leurs copolymères, et le polyéthylène téraphtalate.

7. Procédé selon l'une quelconque des revendications précédentes, **caractérisé en ce que**, à l'issue de l'étape e), le capot d'encapsulation (400) et/ou le substrat de support (200) ont une épaisseur inférieure ou égale à 100µm, et de préférence, inférieure à 50µm.

8. Procédé selon l'une quelconque des revendications précédentes, **caractérisé en ce que** le composant microélectronique (300) est un dispositif électrochimique telle qu'une microbatterie au lithium.

9. Procédé selon l'une quelconque des revendications précédentes, **caractérisé en ce que** plusieurs dispositifs microélectroniques (300), identiques ou différents, sont disposés sur la première face (201) du substrat de support (200) et/ou sur la première face principale (401) du capot d'encapsulation (400).

10. Structure microélectronique comprenant :
- un dispositif microélectronique (300), par exemple, un dispositif électrochimique telle qu'une microbatterie au lithium,
- un substrat de support (200), en un premier matériau, comprenant une première face principale (201) sur laquelle est disposé le dispositif microélectronique (300), une seconde face principale (202) opposée à la première face principale (201), et une face latérale,
- une couche de collage (500), en un deuxième matériau, disposée sur la première face (201) du substrat (200), autour du dispositif microélectronique (300),
- un capot d'encapsulation (400), en un troisième matériau, comprenant une première face principale (401), une seconde face principale (402), opposée à la première face principale (401), et une face latérale, fixé sur la couche de collage (500), et positionner de manière à encapsuler le dispositif microélectronique (300),
- une couche de protection latérale (600) en un quatrième matériau recouvrant la face latérale du substrat de support (200), la face latérale du capot d'encapsulation (400), le pourtour de la seconde face (402) du capot d'encapsulation (400), et le pourtour de la seconde face (202) du substrat de support (200), la couche de protection latérale (600) délimitant une zone protégée,
- l'épaisseur du substrat de support (200) et/ou du capot d'encapsulation (400) en dehors de la zone protégée étant inférieure, respectivement, à l'épaisseur du substrat de support (200) et/ou du capot de manipulation (400) au niveau de la zone protégée.

11. Structure selon la revendication 10, **caractérisée en ce que** le premier matériau et/ou le troisième matériau sont choisis parmi le verre et le silicium.

12. Structure selon l'une des revendications 10 et 11, **caractérisée en ce que** la couche de collage (300) recouvre totalement le dispositif microélectronique (300).

13. Structure selon l'une des revendications 10 et 11, **caractérisée en ce que** la couche de collage (600) forme un cordon de scellement autour du dispositif microélectronique (300).

14. Structure selon l'une quelconque des revendications 10 à 13, **caractérisée en ce que** le capot d'encapsulation (400) et/ou le substrat de support (200) ont une épaisseur inférieure ou égale à 100µm, et de préférence, inférieure à 50µm, en dehors de la zone protégée.

15. Structure selon l'une quelconque des revendications 10 à 14, **caractérisée en ce que** la couche de protection latérale (600) recouvre le pourtour de la première face principale (201) du substrat de support (200) et/ou le pourtour de la première face principale (401) du capot d'encapsulation (400), de préférence sur une longueur allant de 1mm à 5mm.

16. Structure selon l'une quelconque des revendications 10 à 15, **caractérisée en ce que** la couche de protection latérale (600) recouvre le pourtour de la seconde face principale (202) du substrat de support (200) et/ou le pourtour de la seconde face principale (402) du capot d'encapsulation (400), de préférence sur une longueur allant de 1mm à 5mm.

## Patentansprüche

1. Verfahren zur Einkapselung einer mikroelektronischen Vorrichtung (300), die auf einem Trägersubstrat (200) angeordnet ist, mit einer Einkapselungshaube (400), umfassend die folgenden aufeinanderfolgenden Schritte:
a) Bereitstellen eines Trägersubstrats (200) aus einem ersten Material, umfassend eine erste Hauptfläche (201), auf der eine mikroelektronische Vorrichtung (300) angeordnet ist, eine zweite Hauptfläche (202), die der ersten Hauptfläche (201) gegenüberliegt, und eine laterale Fläche,
b) Aufbringen einer Klebeschicht (500) aus einem zweiten Material auf die erste Fläche (201) des Substrats (200) um die mikroelektronische Vorrichtung (300) herum,
c) Positionieren einer Einkapselungshaube (400) aus einem dritten Material, die eine erste Hauptfläche (401), eine zweite Hauptfläche (402), die der ersten Hauptfläche gegenüberliegt (401), und eine laterale Fläche umfasst, auf der Klebeschicht (500), solcherart, dass die Einkapselungshaube (400) auf dem Trägersubstrat (200) befestigt wird, und solcherart, dass die mikroelektronische Vorrichtung (300) eingekapselt wird,
d) Aufbringen einer lateralen Schutzschicht (600) aus einem vierten Material auf der lateralen Fläche des Trägersubstrats (200), auf der lateralen Fläche der Einkapselungshaube (400), auf dem Rand der zweiten Fläche (402) der Einkapselungshaube (400) und auf dem Rand der zweiten Fläche (202) des Trägersubstrats (200), wobei die laterale Schutzschicht (600) einen geschützten Bereich begrenzt,
e) Ausdünnen der zweiten Hauptfläche (202) des Trägersubstrats (200) und/oder der zweiten Hauptfläche (402) der Einkapselungshaube (400) außerhalb des geschützten Bereichs durch chemische Ätzung.

2. Verfahren nach Anspruch 1, **dadurch gekennzeichnet, dass** das erste Material und/oder das dritte Material aus Glas und Silizium ausgewählt ist.

3. Verfahren nach einem der Ansprüche 1 und 2, **dadurch gekennzeichnet, dass** das erste Material und das dritte Material identisch oder unterschiedlich sind.

4. Verfahren nach einem der Ansprüche 1 bis 3, **dadurch gekennzeichnet, dass** beim Schritt b) die Klebeschicht (300) die mikroelektronische Vorrichtung (300) vollständig bedeckt.

5. Verfahren nach einem der Ansprüche 1 bis 3, **dadurch gekennzeichnet, dass** während dem Schritt b) die Klebeschicht (600) eine Dichtschnur um die mikroelektronische Vorrichtung (300) herum bildet.

6. Verfahren nach einem der vorhergehenden Ansprüche, **dadurch gekennzeichnet, dass** das zweite Material und/oder das vierte Material ein Polymermaterial ist, das aus Epoxiden, Ethern, Polysiloxanen, Acrylen, einem ihrer Copolymere und Polyethylenterephthalat ausgewählt ist.

7. Verfahren nach einem der vorhergehenden Ansprüche, **dadurch gekennzeichnet, dass** am Ende des Schrittes e) die Einkapselungshaube (400) und/oder das Trägersubstrat (200) eine Dichte geringer als oder gleich 100 µm und vorzugsweise geringer als 50 µm aufweist.

8. Verfahren nach einem der vorhergehenden Ansprüche, **dadurch gekennzeichnet, dass** das mikroelektronische Bauteil (300) eine elektrochemische Vorrichtung wie eine Lithium-Mikrobatterie ist.

9. Verfahren nach einem der vorhergehenden Ansprüche, **dadurch gekennzeichnet, dass** mehrere mikroelektronische Vorrichtungen (300), die identisch oder unterschiedlich sind, auf der ersten Fläche (201) des Trägersubstrats (200) und/oder auf der ersten Hauptfläche (401) der Einkapselungshaube (400) angeordnet sind.

10. Mikroelektronische Struktur, Folgendes umfassend:
- eine mikroelektronische Vorrichtung (300), zum Beispiel eine elektrochemische Vorrichtung wie eine Lithium-Mikrobatterie,
- ein Trägersubstrat (200) aus einem ersten Material, umfassend eine erste Hauptfläche (201), auf der die mikroelektronische Vorrichtung (300) angeordnet ist, eine zweite Hauptfläche (202) die der ersten Hauptfläche (201) gegenüberliegt, und eine laterale Fläche,
- eine Klebeschicht (500) aus einem zweiten Material, angeordnet auf der ersten Fläche (201) des Substrats (200) um die mikroelektronische Vorrichtung (300) herum,
- eine Einkapselungshaube (400) aus einem dritten Material, umfassend eine erste Hauptfläche (401), eine zweite Hauptfläche (402), die der ersten Hauptfläche (401) gegenüberliegt, und eine laterale Fläche, die auf der Klebeschicht (500) befestigt ist, und solcherart positionieren, dass die mikroelektronische Vorrichtung (300) eingekapselt wird,
- eine laterale Schutzschicht (600) aus einem vierten Material, die die laterale Fläche des Trägersubstrats (200), die laterale Fläche der Einkapselungshaube (400), den Rand der zweiten Fläche (402) der Einkapselungshaube (400) und den Rand der zweiten Fläche (202) des Trägersubstrats (200) bedeckt, wobei die laterale Schutzschicht (600) einen geschützten Bereich begrenzt,
- wobei die Stärke des Trägersubstrats (200) und/oder der Einkapselungshaube (400) außerhalb des geschützten Bereichs jeweils geringer ist als die Stärke des Trägersubstrats (200) und/oder der Manipulationshaube (400) auf der Höhe des geschützten Bereichs.

11. Struktur nach Anspruch 10, **dadurch gekennzeichnet, dass** das erste Material und/oder das dritte Material aus Glas und Silizium ausgewählt ist.

12. Struktur nach einem der Ansprüche 10 und 11, **dadurch gekennzeichnet, dass** die Klebeschicht (300) die mikroelektronische Vorrichtung (300) vollständig bedeckt.

13. Struktur nach einem der Ansprüche 10 und 11, **dadurch gekennzeichnet, dass** die Klebeschicht (600) eine Dichtschnur um die mikroelektronische Vorrichtung (300) bildet.

14. Struktur nach einem der Ansprüche 10 bis 13, **dadurch gekennzeichnet, dass** die Einkapselungshaube (400) und/oder das Trägersubstrat (200) außerhalb des geschützten Bereichs eine Stärke geringer als oder gleich 100 µm und vorzugsweise geringer als 50 µm aufweisen.

15. Struktur nach einem der Ansprüche 10 bis 14, **dadurch gekennzeichnet, dass** die laterale Schutzschicht (600) den Rand der ersten Hauptfläche (201) des Trägersubstrats (200) und/oder den Rand der ersten Hauptfläche (401) der Einkapselungshaube (400) bedeckt, vorzugsweise über eine Länge zwischen 1 mm und 5 mm.

16. Struktur nach einem der Ansprüche 10 bis 15, **dadurch gekennzeichnet, dass** die laterale Schutzschicht (600) den Rand der zweiten Hauptfläche (202) des Trägersubstrats (200) und/oder den Rand der zweiten Hauptfläche (402) der Einkapselungshaube (400) bedeckt, vorzugsweise über eine Länge zwischen 1 mm und 5 mm.

## Claims

1. Process for encapsulation of a microelectronic device (300) placed on a support substrate (200), with an encapsulation cover (400) comprising the following successive steps:
a) supply a support substrate (200) made of a first material, comprising a first principal face (201) on which a microelectronic device (300) is placed, a second principal face (202) opposite the first principal face (201), and a lateral face,
b) deposit a bonding layer (500) made of a second material on the first principal face (201) of the substrate (200), around the microelectronic device (300),
c) position an encapsulation cover (400) made of a third material, comprising a first principal face (401), a second principal face (402) opposite the first principal face (401), and a lateral face on the bonding layer (500), so as to fix the encapsulation cover (400) on the support substrate (200) so as to encapsulate the microelectronic device (300),
d) deposit a lateral protection layer (600) made of a fourth material on the lateral face of the support substrate (200), on the lateral face of the encapsulation cover (400), on the periphery of the second principal face (402) of the encapsulation cover (400), and around the periphery of the second principal face (202) of the support substrate (200), the lateral protection layer (600) delimiting a protected zone,
e) thinning of the second principal face (202) of the support substrate (200) and/or the second principal face (402) of the encapsulation cover (400) outside the protected zone, by chemical etching.

2. Process according to claim 1, wherein the first material and/or the third material are chosen among glass and silicon.

3. Process according to one of claims 1 and 2, wherein the first material and the third material are identical or different.

4. Process according to one of claims 1 to 3, wherein, during step b), the bonding layer (300) entirely covers the microelectronic device (300).

5. Process according to one of claims 1 to 3, wherein, during step b), the bonding layer (600) forms a sealing bead around the microelectronic device (300).

6. Process according to any one of the preceding claims, wherein the second material and/or the fourth material is polymer material chosen from among epoxides, ethers, polysiloxanes, acrylics, one of their copolymers, and polyethylene teraphthalate.

7. Process according to any one of the preceding claims, wherein, after step e), the thickness of the encapsulation cover (400) and/or the thickness of the support substrate (200) is less than or equal to 100µm, and preferably less than 50µm.

8. Process according to any one of the preceding claims, wherein the microelectronic device (300) is an electrochemical device such as a lithium-microbattery.

9. Process according to any one of the preceding claims, wherein several microelectronic devices (300), identical or different, are disposed on the first face (201) of the support substrate (200) and/or on the first face (401) of the encapsulation cover (400).

10. Microelectronic structure comprising:
- a microelectronic device (300), for example an electrochemical device such as a lithium microbattery,
- a support substrate (200) made of a first material, comprising a first principal face (201) on which the microelectronic device (300) is placed, a second principal face (202) opposite the first principal face (201), and a lateral face,
- a bonding layer (500) made of a second material, placed on the first principal face (201) of the support substrate (200), around the microelectronic device (300),
- an encapsulation cover (400) made of a third material, comprising a first principal face (401), a second principal face (402) opposite the first principal face (401), and a lateral face, fixed on the bonding layer (500), and positioned so as to encapsulate the microelectronic device (300),
- a lateral protection layer (600) made of a fourth material covering the lateral face of the support substrate (200), the lateral face of the encapsulation cover (400), the periphery of the second principal face (402) of the encapsulation cover (400), and the periphery of the second principal face (202) of the support substrate (200), the lateral protection layer (600) delimiting a protected zone,
- the thickness of the support substrate (200) and/or the encapsulation cover (400) outside the protected zone being less than the thickness of the support substrate (200) and/or the manipulation cover (400) at the protected zone, respectively.

11. Structure according to claim 10, wherein the first material and/or the third material is chosen from among glass and silicon.

12. Structure according to one of claims 10 and 11, wherein the bonding layer (300) entirely covers the microelectronic device (300).

13. Structure according to one of claims 10 and 11, wherein the bonding layer (300) forms a sealing bead around the microelectronic device (300).

14. Structure according to one of claims 10 to 13, wherein the thickness of the encapsulation cover (400) and/or the thickness of the support substrate (200) is less than or equal to 100µm, and preferably less than 50µm, outside the protected zone.

15. Structure according to one of claims 10 to 14, wherein the lateral protection layer (600) covers the periphery of the first principal face (201) of the support substrate (200) and/or the periphery of the first principal face (401) of the encapsulation cover (400), preferably on a length ranging from 1mm to 5mm.

16. Structure according to one of claims 10 to 15, wherein the lateral protection layer (600) covers the periphery of the second principal face (202) of the support substrate (200) and/or the periphery of the second principal face (402) of the encapsulation cover (400), preferably on a length ranging from 1mm to 5mm.
